Europäisches Patentamt

European Patent Office

Office européen des brevets

(11) Veröffentlichungsnummer: **0 214 421**
**A1**

## (12) EUROPÄISCHE PATENTANMELDUNG

(21) Anmeldenummer: 86110075.8

(22) Anmeldetag: 22.07.86

(51) Int. Cl.⁴: **H01L 21/316**

(30) Priorität: 09.08.85 DE 3528712

(43) Veröffentlichungstag der Anmeldung:
18.03.87 Patentblatt 87/12

(84) Benannte Vertragsstaaten:
**AT DE FR GB IT**

(71) Anmelder: **Siemens Aktiengesellschaft Berlin und München**
**Wittelsbacherplatz 2**
**D-8000 München 2(DE)**

(72) Erfinder: **Hönlein, Wolfgang, Dr.**
**Ludwig-Thoma-Strasse 60**
**D-8025 Unterhaching(DE)**

(54) **Verfahren zum Herstellen von Dünnoxidschichten auf durch Tiegelziehen hergestellten Siliziumsubstraten.**

(57) Zur Verbesserung der Qualität in bezug auf Durchbruchseigenschaften bei Strombelastung werden Dünnoxidschichten auf durch Tiegelziehen hergestellten Siliziumsubstraten in einem zweistufigen Oxidationsprozeß hergestellt. Dabei besteht die erste Stufe aus einer bei 800°C in feuchter Atmosphäre durchgeführten Oxidationsphase (III) und die zweite Stufe aus einer in Inertgasatmosphäre bei mindestens 900°C durchgeführten Temperphase (V). Das Verfahren wird verwendet zur Herstellung von Dünnoxidschichten (7 bis 50 nm) in der VLSI-Technik.

EP 0 214 421 A1

# Verfahren zum Herstellen von Dünnoxidschichten auf durch Tiegelziehen hergestellten Siliziumsubstraten.

Die Erfindung betrifft ein Verfahren zum Herstellen von Dünnoxidschichten auf durch Tiegelziehen hergestellten Siliziumsubstraten, wie sie insbesondere zur Fertigung von integrierten Halbleiterschaltungen in der VLSI (= very large scale integration)-Technik verwendet werden, durch einen Oxidations- und Temperprozeß mit mehreren Temperaturzyklen im Bereich zwischen 800 und 900°C.

Beim Übergang von durch Zonenschmelzen auf durch Tiegelziehen hergestelltem Silizium-Grundmaterial kommt es bei Anwendung einer Standard-Oxidation bei 900°C in trockener Oxidationsatmosphäre mit und ohne Beimischung von Chlorwasserstoffgas zu einer wesentlichen Verschlechterung der Durchbruchseigenschaften der so hergestellten dünnen Oxide (7 bis 50 nm). Insbesondere steigt der Anteil von Frühdurchbrüchen und defektbedingten Durchbrüchen bei mittleren Feldstärken. Auch die Ausbeute eines Streßtests, der die Langzeitbelastung unter Betriebsbedingungen simuliert, ist bei dünnen, unter Standard-Bedingungen erzeugten Oxidschichten auf tiegelgezogenem Grundmaterial wesentlich geringer als auf zonengezogenem Silizium.

Bei der Entwicklung höchstintegrierter Speicher und anderer VLSI-Bausteine sind aber sehr dünne Oxidschichten mit sehr guten Durchbruchseigenschaften die Voraussetzung für die Funktion des Bauelements.

Da aus Rationalitätsgründen größere Kristallscheibendurch messer in der Fertigung verwendet werden müssen und diese durch Zonenschmelzen nicht herstellbar sind, muß auf tiegelgezogenes Silizium als Ausgangsmaterial für integrierte Halbleiterschaltungen übergegangen werden.

Aufgabe der Erfindung ist es, unter Verwendung von durch Tiegelziehen hergestellten Siliziumkristallscheiben als Substrate Dünnoxidschichten herzustellen, die bezüglich ihrer Durchbruchseigenschaften den Anforderungen in der VLSI-Technologie genügen.

Aus einem Bericht von Chiou und Shive aus den Proc. 3rd Int. Symp. on VLSI Science and Technology, Electrochem. Soc. Proc. Vol. 85-5, Seiten 429 bis 435, insbesondere Seiten 432/433, ist bekannt, zur Verbesserung der Qualität von Dünnoxidschichten einen Vorprozeß auf nicht mit Strukturen versehenen Siliziumkristallscheiben durchzuführen, der mehrere Hochtemperaturzyklen (denuded-zone-process) enthält. Dieser Prozeß, der sehr lange dauert (24 Stunden) und nicht sehr stabil ist, bringt in bezug auf Ausbeuteverbesserung nicht den gewünschten Erfolg.

In der Halbleiterpraxis sind auch zur Qualitätsverbesserung von Dünnoxiden verschiedene Reinigungs- und Schichtabtragsverfahren bekannt, die aber wegen des hohen Schichtabtrags und der hohen Temperaturbelastung nicht innerhalb eines VLSI-Gesamtprozesses ausführbar sind und -als Vorprozeß vor Beginn eines Gesamtprozesses ausgeführt - nicht zu einer wesentlich verbesserten Oxidqualität führen.

Die Erfindung löst die gestellte Aufgabe durch ein Verfahren der eingangs genannten Art dadurch, daß der Oxidations- und Temperprozeß in zwei Stufen durchgeführt wird:

a) einer Oxidationsphase bei 800°C in feuchter Atmosphäre und

b) einer Temperphase bei 900°C in Inertgasatmosphäre.

Solchermaßen hergestellte Dünnoxide, die mit einer Polysilizium-Elektrode (d = 300 nm, Phosphor dotiert) versehen werden, zeigen auf tiegelgezogenem Silizium gegenüber dem bekannten Oxidationsprozeß bei 900°C in trockener Atmosphäre wesentlich verbesserte Durchbruchseigenschaften beim Strombelastungstest.

Durch Anwendung des erfindungsgemäßen zweistufigen Oxidationsprozesses zur Herstellung von Dünnoxidschichten konnten auf tiegelgezogenem Material gleich gute Ergebnisse in bezug auf Durchbruchseigenschaften erzielt werden wie bei der bekannten Trockenoxidation auf zonengezogenem Material. Die Vergleichstest wurden auf identischen Kondensatorflächen durchgeführt. Der Standard-Oxidationsprozeß an zonengezogenem Material wurde bei 900°C in einer Sauerstoff-Argon-Atmosphäre mit $O_2 : Ar = 1 : 4$ und 4 % HCl durchgeführt. Die Schichtdicke des Trockenoxids betrug 12,4 nm. Das erfindungsgemäße Verfahren wurde mit einer Feuchtoxidation in Sauerstoff/Wasserstoff-Atmosphäre bei 800°C und anschließender 900°C-Temperung in Stickstoff durchgeführt; die Schichtdicke des Feuchtoxids betrug 8,7 nm.

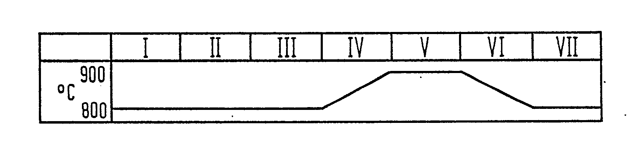

Weitere Ausgestaltungen der Erfindung ergeben sich aus den Unteransprüchen; Einzelheiten werden anhand der Figur noch näher erläutert.

Die Figur zeigt das Temperaturprofil zwischen 800 und 900°C bei der Durchführung der erfindungsgemäßen Feuchtoxidation mit anschließender Temperung in sieben Prozeßschritten. Dabei erfolgen die Prozeßschritte I -VII, die in der Horizontalen aufgetragen sind, mit folgenden Parametern:

I Spülen des Oxidationsrohres in einem $O_2/HCl_{gas}$ -Ge misch (10 sltr/min $O_2$ (= standard Liter pro Minute) und 400 scm³/min HCl) 10 Minuten lang bei 800°C.

II Einfahren der Substrate in die Oxidationszone in Stickstoff-Atmosphäre (10 sltr/min) 20 Minuten bei 800°C.

III Feuchtoxidation in $O_2/H_2$-Gemisch (9 sltr/min $O_2$ und 2 sltr/min $H_2$) bei 800°C mit einer Zeitdauer von 15 Minuten für eine Oxidschichtdicke von 8,7 nm.

IV Temperaturerhöhung (ramp up) auf 900°C in Stickstoff-oder Argon-Atmosphäre (10 sltr/min) in 10 Minuten.

V Temperung bei 900°C in Stickstoff-oder Argon-Atmosphäre (10 sltr/min) 15 Minuten lang.

VI Absenken der Temperatur (ramp down) auf 800°C in Stickstoff-oder Argon-Atmosphäre (10 sltr/min) während einer Zeitdauer von 30 Minuten und

VII Ausfahren der Substrate aus der Temperzone in Stickstoff-Atmosphäre (10 sltr/min) bei 800°C in 20 Minuten.

## Ansprüche

1. Verfahren zum Herstellen von Dünnoxidschichten auf durch Tiegelziehen hergestellten Siliziumsubstraten, wie sie insbesondere zur Fertigung von integrierten Halbleiterschaltungen in der VLSI-Technik verwendet werden, durch einen Oxidations-und Temperprozeß mit mehreren Temperaturzyklen im Bereich zwischen 800 und 900°C, **dadurch gekennzeichnet,** daß der Oxidations-und Temperprozeß in zwei Stufen durchgeführt wird:

a) einer Oxidationsphase (III) bei 800°C in feuchter Atmosphäre und

b) einer Temperphase (IV -V) bei mindestens 900°C in Inertgasatmosphäre.

2. Verfahren nach Anspruch 1, **dadurch gekennzeichnet,** daß die feuchte Atmosphäre bei der Oxidation (III) durch ein $O_2/H_2$-Gemisch in Verhältnis $O_2 : H_2$ = 4,5 : 1 hergestellt wird und die Zeitdauer der Oxidation in Abhängigkeit von der Schichtdicke auf mindestens 15 Minuten eingestellt wird.

3. Verfahren nach Anspruch 1 und 2, **dadurch gekennzeichnet,** daß bei der Temperphase (V) als Inertgas Stickstoff oder Edelgase verwendet werden und die Temperzeit auf mindestens 10 Minuten eingestellt wird.

4. Verfahren nach mindestens einem der Ansprüche 1 bis 3, **dadurch gekennzeichnet,** daß vor der Oxidationsphase (III) eine 10 minütigen Behandlung in einer Sauerstoff/Chlorwasserstoff-Atmosphäre bei 800° (I) und eine nachfolgende 20 minütigen Behandung in Stickstoff-oder Edelgas-Atmosphäre (II) durchgeführt wird.

5. Verfahren nach mindestens einem der Ansprüche 1 bis 4, **dadurch gekennzeichnet** , daß die Substrate vor (IV) und nach der bei 900°C erfolgenden Temperung (V) mindestens 10 bzw. 30 Minuten auf 800°C in Stickstoff-Atmosphäre gehalten werden.

| | | I | II | III | IV | V | VI | VII |
|---|---|---|---|---|---|---|---|---|

°C 900 / 800

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 167 208 (PHILIPS) <br> * Zusammenfassung; Seite 3, Zeilen 17-28; Seite 4, Zeilen 3-16 * | 1,3 | H 01 L 21/316 |
| | --- | | |
| A | EP-A-0 087 581 (SIEMENS AG) <br> * Seite 3, Zeilen 20-37; Seite 4, Zeilen 16-31; Seite 5; Zeilen 1-15 * | 1-5 | |
| | --- | | |
| A | US-A-4 214 919 (YOUNG) | | |
| | ----- | | |

| RECHERCHIERTE SACHGEBIETE (Int. Cl.4) |
|---|
| H 01 L 21/316 <br> C 30 B 33/00 |

Der vorliegende Recherchenbericht wurde für alle Patentansprüche erstellt.

| Recherchenort | Abschlußdatum der Recherche | Prüfer |
|---|---|---|
| BERLIN | 04-11-1986 | PRETZEL B.C. |